# FASCICULE DE BREVET EUROPEEN

(11) **EP 4 571 572 B1**
(45) Date de publication et mention de la délivrance du brevet: **22.07.2026**
(21) Numéro de dépôt: 24217880.4
(22) Date de dépôt: 05.12.2024
(51) Int. Cl.: G06K 19/02, G06K 19/07, G06K 19/077

(54) **CARTE À PUCE MÉTALLIQUE ET PROCÉDÉ DE FABRICATION D'UNE CARTE À PUCE MÉTALLIQUE**
METALLCHIPKARTE UND VERFAHREN ZUR HERSTELLUNG EINER METALLCHIPKARTE
METAL SMART CARD AND METHOD FOR MANUFACTURING METAL SMART CARD

(30) Priorité: 14.12.2023 FR 2314241
(43) Date de publication de la demande: 18.06.2025
(73) Titulaire: Idemia France, 92400 Courbevoie (FR)
(72) Inventeur: ALI, Ahmed, 92400 Courbevoie (FR); GROULT, Tiphaine, 92400 Courbevoie (FR)
(74) Mandataire: Idemia

(56) Documents cités:
- WO-A1-2017/191373
- US-A1- 2018 232 617
- US-A1- 2023 067 229
- US-A1- 2023 237 305

## Description

### Domaine Technique

L'invention se rapporte au domaine des cartes à puce et porte plus particulièrement sur les cartes à puce métalliques aptes à fonctionner en mode sans contact.

### Technique antérieure

L'utilisation des cartes à puce (ou cartes à microcircuit) est aujourd'hui largement répandue dans la vie quotidienne. De telles cartes sont par exemple utilisées comme cartes bancaires, cartes de fidélité, cartes d'accès etc., et peuvent prendre divers formats selon leurs utilisations respectives. Les cartes à puce peuvent être conçues pour réaliser divers types de fonctions, notamment pour effectuer des transactions, telles que des transactions bancaires (transaction de paiement, de transfert...), des transactions d'authentification, etc.

De façon connue, une carte à puce comprend généralement un corps de carte qui est équipé d'une puce électronique configurée pour échanger des signaux avec l'extérieur et réaliser diverses fonctions selon l'utilisation souhaitée de la carte. Pour ce faire, les cartes à puce sont munies de moyens de communication permettant d'interagir avec l'extérieur, typiquement avec un lecteur NFC ou lecteur externe.

Traditionnellement, une carte à puce est conçue pour coopérer avec un lecteur NFC externe au moyen de contacts externes accessibles à la surface de la carte. Un lecteur NFC externe peut ainsi positionner des broches de contact appropriées sur les contacts externes de la carte afin d'établir une communication par contact.

Plus récemment, les cartes à puce sans contact ont connu un essor croissant en raison du gain en rapidité et en simplicité liées aux transactions sans contact. Pour ce faire, les cartes sans contact embarquent une antenne radiofréquence (RF) permettant l'échange de signaux RF avec un lecteur NFC externe (par exemple en champ proche NFC pour « Near Field Communication » en anglais). Cette antenne RF est généralement composée d'une pluralité de spires conductrices qui s'étendent dans le corps de la carte.

La structure et l'apparence des cartes à puce peuvent varier selon le cas. Les cartes à puce métalliques connaissent en particulier un intérêt croissant en raison notamment de l'aspect esthétique attractif de ces cartes (reflets métalliques, effet brossé en surface etc.), de l'impression de qualité qu'elles peuvent procurer (poids appréciable du métal, esthétique haute gamme), ou encore de la connotation de prestige qui y est associée pour leurs utilisateurs. En raison notamment de leur poids important et de l'impression de haute qualité qu'elles dégagent, ces cartes sont privilégiées par certains utilisateurs pour servir de marqueur social et d'élément différenciant.

Il a cependant été observé que la présence de métal dans le corps d'une carte à puce pose des difficultés majeures lorsque la carte embarque une antenne RF pour fonctionner en mode sans contact. Le métal agit comme blindage électromagnétique et bloque ou gêne les signaux RF échangés par l'antenne RF avec l'extérieur. Le métal présent dans le corps de carte peut ainsi perturber les communications sans contact d'une carte à puce avec un lecteur NFC externe et gêner par exemple la réalisation d'une transaction sans contact (de paiement ou autre).

Une solution connue consiste à utiliser une couche de ferrite entre l'antenne et la feuille de métal. Bien que simple, cette solution rend la fabrication de la carte complexe et la carte ne peut communiquer avec le lecteur interrogateur que d'un seul côté.

Le document US 2023/067229 A1 décrit une carte à puce métallique apte à fonctionner en mode sans contact et qui comprend une pluralité de couches métalliques avec au moins une couche métallique supérieure et une couche métallique inférieure, et une antenne RFcomprenant au moins une spire conductrice, disposée dans une cavité interne ménagée entre les couches métalliques supérieure et inférieure. Les couches métalliques supérieure et inférieure comprennent chacune une zone d'évidemment partiel Z1, Z2 en regard de l'au moins une spire, chaque zone d'évidement partiel comportant au moins une ouverture au travers de l'épaisseur de la couche métallique et chaque zone d'évidement partiel étant partiellement recouverte par au moins une protrusion métallique s'étendant depuis un bord de la zone d'évidement partiel de sorte à définir le contour de ladite au moins une ouverture. Les spires de l'antenne RF sont partiellement recouvertes par les protrusions métalliques, permettant une connexion entre les spires de l'antenne RF et les protrusions métalliques.

Le document US 2023/237305 A1 décrit une carte à puce métallique et sans contact avec une « mini antenne relai » intégrée. L'antenne relais est intégrée dans un insert métallique et fonctionne en tandem avec le module RFID de la carte qui possède sa propre antenne. Ladite antenne relai peut être configurée sous forme de spirales imbriquées et « présenter une surface totale égale à 6 ou 7 fois la surface de l'antenne du module ».

Le document US 2018/232617 A1 décrit une carte à puce métallique apte à fonctionner en mode sans contact conçue pour améliorer la communication sans contact grâce à une fente dans le métal qui canalise le courant induit par le champ magnétique. La carte de ce document comporte une couche métallique dans laquelle est formée une cavité. Un module (RFIC chip) est encarté d'une part dans cette cavité et, d'autre part, un inlay est disposé dans un renfoncement de la cavité. L'inlay comporte deux antennes enroulées de part et d'autre de l'inlay et connectées l'une à l'autre par un via. La première antenne comporte une portion large, et la deuxième antenne comporte des îlots. En faisant varier le nombre d'îlots, la taille du condensateur effectif formé par la partie large et la pluralité d'îlots peut être réglée. L'adaptation de l'impédance peut donc être facilitée par le réglage de la capacité globale.

Une autre solution pertinente consiste à utiliser une antenne de taille réduite insérée à l'intérieur ou en superposition avec une cavité (absence de métal) réalisée dans une feuille de métal, la cavité étant reliée au bord extérieur de la couche de métal au moyen d'une fente. Dans cette configuration, la couche métallique entoure l'antenne NFC et présente donc une surface physique plus grande que celle de l'antenne et occupe généralement la totalité de la taille de la carte.

Les lignes de champ magnétique étant des lignes fermées, le champ magnétique d'interrogation incident sur la couche métallique environnante, dans une telle topologie, sera donc détourné du métal: les lignes de champ magnétique à la périphérie du métal seront détournées vers l'extérieur tandis que les lignes proches de la cavité seront détournées vers l'intérieur, traversant ainsi la zone de l'antenne et s'ajoutant au flux magnétique normal traversant l'antenne, rendant sa zone effective plus grande que dans le cas où elle aurait été utilisée sans ce métal environnant.

Bien que la technique décrite ci-dessus présente un bon comportement NFC, elle peut souffrir d'un problème technique majeur. Comme l'insert d'antenne est constitué d'un circuit imprimé, ce circuit est mis en œuvre par la technologie classique des circuits imprimés sur un substrat diélectrique tel que, par exemple, le matériau FR4. Les traces d'antenne sont réalisées dans ce cas par un processus classique de PCB soustractif (gravure mécanique ou chimique) avec une croissance métallique optionnelle électrodéposée ou sans électrolyse pour atteindre une certaine épaisseur. Le processus classique de fabrication de la carte comprend alors au moins un processus de remplissage de la zone de la cavité située au-dessus de l'antenne, afin d'assurer l'étanchéité entre ces deux éléments mécaniquement différents, c'est-à-dire le substrat du circuit imprimé et la barrette métallique qui l'entoure. Cette étape de scellement est indispensable pour conférer à l'ensemble du produit un aspect monolithique en vue de satisfaire un certain aspect esthétique, mais surtout pour conférer une stabilité mécanique à la carte en l'empêchant de se déchirer au cours des différents cycles de pliage tout au long du cycle de vie du produit.

Un problème majeur se pose pour que ce processus de scellement/résine soit couronné de succès et joue le rôle décrit ci-dessus : comme l'antenne NFC est acheminée sous la forme de boucles fermées typiques, la zone centrale de l'antenne du circuit imprimé est parfaitement dépourvue de métal alors que les tours de l'antenne à la périphérie portent les tours de l'antenne. Cela crée une asymétrie structurelle sur la surface du circuit imprimé des deux côtés du circuit. Ce manque d'homogénéité entraîne un manque d'adhérence et, par conséquent, un manque de l'aspect monolithique prévu et, enfin, une fragilité de l'ensemble de la carte. En outre, plus la cavité est grande, plus ce problème est grave.

Il existe donc un besoin pour des cartes à puce métalliques performantes (de type RFID par exemple) et de fabrication simple, capables de coopérer efficacement en sans contact avec un terminal externe.

### Exposé de l'invention

La présente invention concerne une carte à puce comprenant :
- un corps de carte formé au moins en partie par une couche métallique comprenant une zone d'évidement et au moins deux couches en plastiques de part et d'autre de la couche métallique;
- au moins une antenne RF disposée dans ou en regard de la zone d'évidement;
- un module comportant une puce RF , le module étant positionné dans une cavité traversante d'une couche en plastique et étant connecté électriquement à l'antenne RF;
- un motif en matériau conducteur connecté en parallèle à ladite au moins une antenne et disposé dans ou en regard de la zone d'évidement et comprenant
   - une zone centrale dont la surface conductrice est inférieure ou égale à 20% de la surface d'une zone centrale circonscrite par ladite antenne
   - au moins deux traces en matériau conducteur (Tᵢ) séparées l'une de l'autre et s'étendant à partir de ladite zone centrale dudit motif, lesdites au moins deux traces en
   matériau conducteur étant distantes l'une de l'autre afin de laisser passer un champ magnétique à travers ladite antenne et configurées de manière à ne pas former de boucle fermée pour éviter la formation de courants de Foucault sur ladite carte, ledit motif en matériau conducteur étant configuré pour former une capacité connectée électriquement à l'antenne, dont la valeur est déterminée pour que la capacité formée par ledit motif associée à la capacité de ladite antenne permette au circuit résonnant formé par l'antenne et ledit motif de résonner à une fréquence de communication déterminée.

L'insertion d'un motif en matériau conducteur dans une zone comprise au centre de l'antenne peut permettre d'améliorer la robustesse de la carte à puce métallique en ajoutant une zone de métal dans une cavité qui n'en contenait pas et qui constituait donc une zone dont la structure était différente de la structure apportée par la couche métallique présente en dehors de la cavité. Le motif étant en matériau conducteur il permet en outre d'apporter une capacité supplémentaire.

Selon certains modes de réalisation, ladite antenne comprend deux enroulements RF (AT1, AT2) connectés entre eux électriquement et situés respectivement de part et d'autre de ladite zone d'évidement, deux motifs en matériau conducteur étant situés respectivement de part et d'autre de ladite zone d'évidement et connectés chacun à l'un des enroulements RF.

Les deux motifs en matériau conducteur peuvent ainsi former une capacité parallèle et peuvent permettre d'améliorer la valeur capacitive de l'ensemble du circuit résonant formé par le motif et l'antenne.

Selon certains modes de réalisation, ladite fréquence de communication déterminée est de 13,56 Mhz et conforme à la norme ISO 14443-2 ou ISO 10373-6.

Selon certains modes de réalisation,
- la au moins une antenne comprend une pluralité de spires,
- la zone centrale dudit motif est de forme ronde et centré sur le centre des spires de l'antenne, et
- les traces dudit motif sont des traces circulaires centrées sur le centre des spires et formant des anneaux autour de la zone centrale ronde du motif, les traces étant séparées les unes des autres chacune par des premières zones circulaires non conductrice s'étendant entre chacune des traces circulaires et une seconde zone rectiligne reliant lesdites premières zones circulaires non conductrices et coupant chacune des traces circulaires conductrices dudit motif de manière à ne pas former de boucle fermée pour éviter la formation de courants de Foucault sur ladite carte,
- les premières zones circulaires non conductrices étant chacune ouvertes de manière à assurer une continuité conductrice entre la zone centrale et les traces dudit motif.

Selon certains modes de réalisation,
- la au moins une antenne comprend une pluralité de spires,
- ledit motif en matériau conducteur comprend une surface centrale conductrice de forme ronde centrée sur le centre des spires de l'antenne et interconnectant une pluralité desdites paires de traces en matériau conducteur,
- lesdites traces en matériau conducteur étant de forme rectangulaires et connectées à ladite surface centrale conductrice par l'une de leur extrémité, l'autre extrémité étant libre, et réparties uniformément autour de ladite zone centrale du motif.

Selon certains modes de réalisation,
- la au moins une antenne comprend une pluralité de spires,
- ledit motif en matériau conducteur comprend une surface centrale conductrice de forme ronde centrée sur le centre des spires de l'antenne et interconnectant une pluralité desdites paires de traces en matériau conducteur,
- lesdites traces en matériau conducteur étant de forme hélicoïdale et connectées à ladite surface centrale conductrice par l'une de leur extrémité, l'autre extrémité étant libre, et réparties uniformément autour de ladite zone centrale du motif.

Selon certains modes de réalisation, les traces en matériau conducteur sont réparties uniformément autour de la surface centrale ronde.

Selon certains modes de réalisation, le nombre de traces conductrices dépend de la valeur de la capacité connectée.

Selon certains modes de réalisation, les traces présentent une largeur configurée pour réduire les courants de Foucault présents sur ladite carte à puce.

Selon un autre aspect, la présente invention concerne un procédé de fabrication d'une carte à puce (CD1) formée au moins en partie par un corps de carte comprenant une couche métallique (103), ladite couche métallique comprenant une zone d'évidement (104), le procédé comprenant :
a) formation (S4) sur ou dans le corps de carte d'au moins une première antenne RF (AT1, AT2) dans ou en regard de la zone d'évidement de la couche métallique ;
b) formation (S6) d'au moins un motif en matériau conducteur au centre de la au moins une antenne connecté en parallèle à ladite au moins une antenne et disposé dans ou en regard de la zone d'évidement, le motif métallique comprenant
   - une zone centrale dont la surface conductrice est inférieure ou égale à 20% de la surface d'une zone centrale circonscrite par ladite antenne
   - au moins deux traces en matériau conducteur (Tᵢ) séparées l'une de l'autre et s'étendant à partir de ladite zone centrale dudit motif, lesdites au moins deux traces métalliques étant distantes l'une de l'autre afin de laisser passer un champ magnétique à travers ladite antenne et configurées de manière à ne pas former de boucle fermée pour éviter la formation de courants de Foucault sur ladite carte,
   ledit motif en matériau conducteur étant configuré pour former une capacité connectée électriquement à l'antenne, dont la valeur est déterminée pour que la capacité formée par ledit motif associée à la capacité de ladite antenne permette au circuit résonnant formé par l'antenne et ledit motif de résonner à une fréquence de communication déterminée
c) assemblage (S8) d'une puce RF de sorte que ladite puce RF soit connectée électriquement à ladite au moins une antenne,
d) dépôt (S10) d'une couche de résine pour sceller la couche métallique et la zone d'évidement comprenant ladite au moins une antenne et ledit au moins un motif métallique.

D'autres caractéristiques et avantages de la présente invention ressortiront de la description faite ci-dessous, en référence aux dessins annexes qui en illustrent un exemple de réalisation dépourvu de tout caractère limitatif.

### Brève description des dessins

La figure 1a représente une vue de la face avant d'une carte à puce selon certains modes de réalisation de l'invention,
La figure 1b représente une vue de de la face arrière d'une carte à puce selon certains modes de réalisation de l'invention,
La figure 2a représente une vue de profil des couches d'une carte à puce non assemblées selon certains modes de réalisation de l'invention,
la figure 2b représente une vue de profil des couches d'une carte à puce assemblées selon certains modes de réalisation de l'invention,
La figure 3 représente un exemple de motif selon un premier mode de réalisation de l'invention,
La figure 4 représente un exemple de motif selon un second mode de réalisation de l'invention,
La figure 5 représente un exemple de motif selon un troisième mode de réalisation de l'invention,
La figure 6 représente un schéma électrique équivalent à l'antenne selon certains modes de réalisation de l'invention,
La figure 7 représente une comparaison entre une courbe de réponse obtenue selon l'art antérieur et selon un mode de réalisation de la présente invention,
La figure 8 représente un mode de réalisation donnant un exemple des dimensions pouvant être utilisées pour le motif,
La figure 9 représente un procédé de fabrication d'une carte à puce selon certains modes de réalisation de l'invention.

### Description des modes de réalisation

Comme indiqué précédemment, l'invention porte sur des cartes à puce métalliques configurées pour fonctionner en mode sans contact, et concerne également un procédé de fabrication de telles cartes à puce. Une « carte à puce métallique » désigne dans le présent document une carte à puce comprenant un métal ou une combinaison (alliage) de métaux, par exemple sous la forme d'une couche métallique ou d'une pluralité de couches métalliques.

Comme indiqué précédemment, une carte à puce sans contact est configurée par nature pour communiquer en sans contact avec l'extérieur, plus particulièrement avec un lecteur NFC externe. A cet effet, une carte à puce sans contact embarque une antenne radiofréquence (RF) pour échanger (recevoir et/ou émettre) des signaux RF avec un lecteur NFC externe. Une telle carte à puce peut en outre avoir la capacité de fonctionner aussi en mode avec contact, en utilisant des contacts externes prévus à cet effet à la surface de la carte : on parle alors de cartes « dual » (ou cartes à double interface de communication), ces cartes étant ainsi capable de fonctionner en mode sans contact et en mode avec contact.

Il existe aujourd'hui une forte demande chez les utilisateurs pour des cartes à puce métalliques, pour notamment les raisons évoquées précédemment (aspects esthétiques, impression de qualité, prestige...). Il est en particulier souhaitable de produire des cartes à puce dont l'essentiel (ou une part importante) du corps de carte est en métal, ou du moins dont le corps de carte comporte une plaque métallique (ou couche métallique), afin d'obtenir une certaine uniformité et qualité dans l'aspect visuel et esthétique de la carte.

Comme mentionné précédemment, lorsque l'antenne présente une zone centrale dépourvue de métal, la surface de la carte présente une asymétrie structurelle, due au fait d'une répartition non homogène de métal sur la carte, la zone centrale de l'antenne du circuit imprimé étant parfaitement dépourvue de métal alors que les tours de l'antenne à la périphérie portent les tours de l'antenne. Cela crée une asymétrie structurelle sur la surface du circuit imprimé des deux côtés du circuit. Pour mieux comprendre le problème, selon certains modes de réalisation, les spires d'antenne ont généralement une épaisseur supérieure à 30µm et peuvent atteindre 90µm, ceci peut donc venir perturber l'homogénéité du matériau d'étanchéité à la surface du circuit imprimé.

.Dans le présent exposé, des exemples de mises en œuvre de l'invention sont décrits en relation avec une carte à puce de type « dual », c'est-à-dire une carte à double interface de communication, ayant la capacité de communiquer aussi bien en mode avec contact (via des contacts externes) qu'en mode sans contact (via une structure d'antenne RF). On notera toutefois que l'invention peut s'appliquer plus généralement à une quelconque carte à puce configurée pour communiquer en sans contact, et ce qu'elle ait la capacité ou non de fonctionner aussi en mode avec contact.

De plus, on considère dans les exemples qui suivent que la carte à puce est une carte bancaire, telle qu'une carte de paiement par exemple. Cette carte à puce peut être conforme à la norme ISO 7816 et peut fonctionner selon le standard EMV, bien que ni l'un ni l'autre de ces aspects ne soit obligatoire pour mettre en œuvre l'invention. Plus généralement, l'invention s'applique à une quelconque carte à puce métallique configurée pour mettre en œuvre une transaction en mode sans contact, y compris des cartes EMV ou des cartes à puce utilisant un autre standard de transaction, par exemple le standard NFC (selon par exemple ISO14443-2 , ISO 10373-6, « EMV Contactless Certification »). De façon générale, la carte à puce de l'invention peut être configurée pour réaliser une transaction d'un type quelconque, telle que des transactions bancaires (transactions de paiement, de transfert, de débit...), des transactions d'authentification, etc.

Sauf indications contraires, les éléments communs ou analogues à plusieurs figures portent les mêmes signes de référence et présentent des caractéristiques identiques ou analogues, de sorte que ces éléments communs ou analogues ne sont généralement pas à nouveau décrits par souci de simplicité.

Les termes « premier(s) » (ou première(s)), « deuxième(s) », etc.) sont utilisés dans ce document par convention arbitraire pour permettre d'identifier et de distinguer différents éléments (tels que des clés, des dispositifs, etc.) mis en œuvre dans les modes de réalisation décrits ci-après.

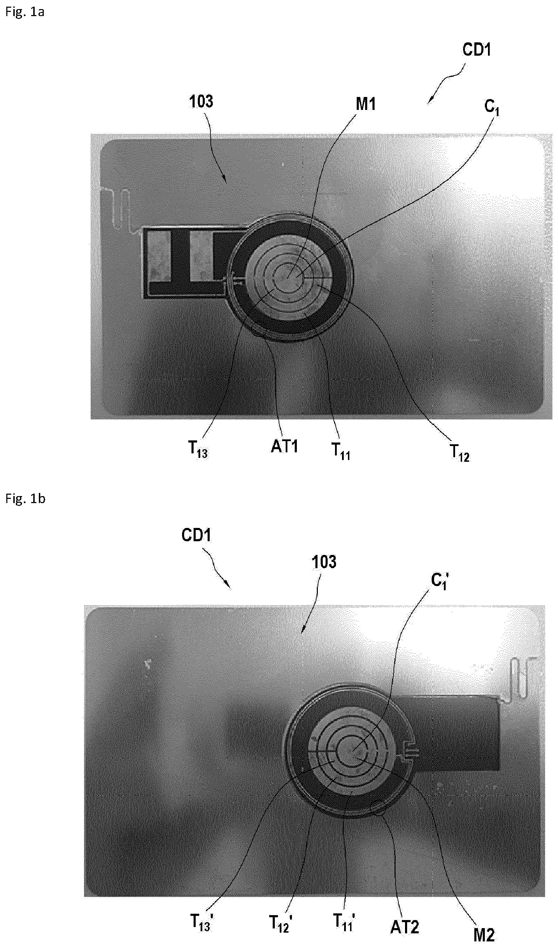

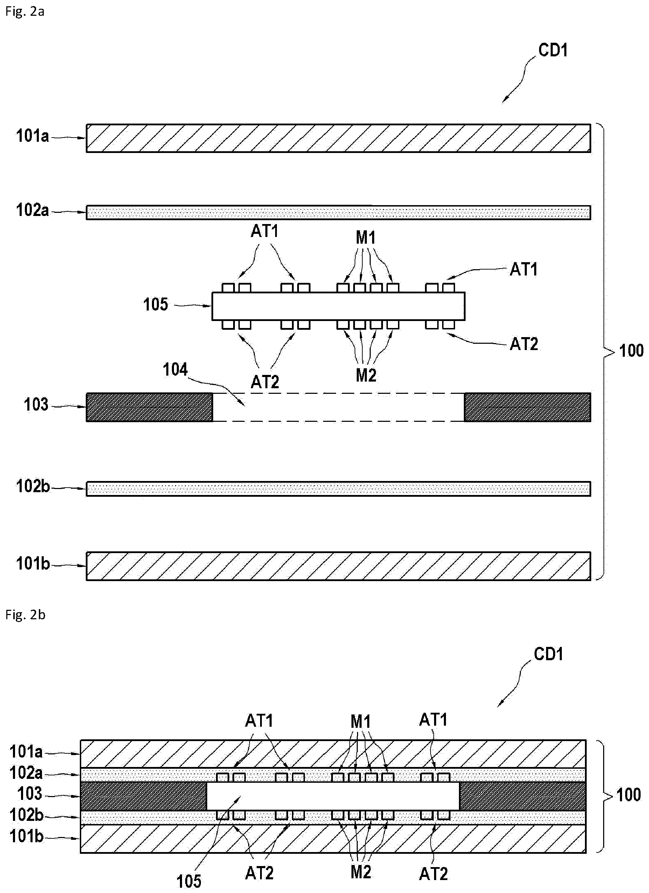

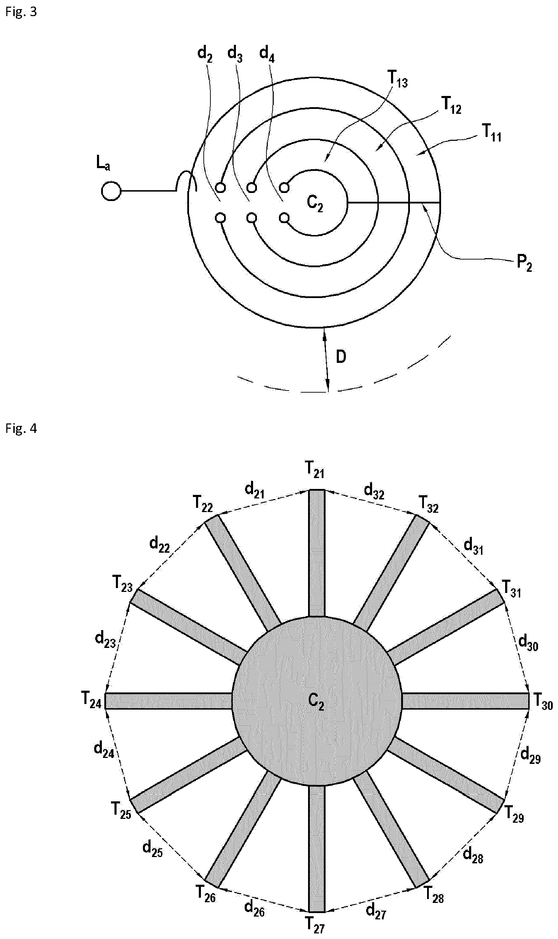

Les figures 1a et 1b représentent une vue de la face avant et une vue de la face arrière d'une carte à puce CD1 selon un mode de réalisation de la présente invention. Si la figure 1a représente une vue de de la face avant, la figure 1b représente une vue de la face arrière et inversement. Le mode de réalisation des figures 1a et 1b est décrit ultérieurement plus en détail dans les figures 2a et 2b et dans la figure 3.

La carte à puce CD1 telle que représentée dans le mode de réalisation des figures 1a et 1b comprend une couche métallique 103, un premier enroulement d'antenne AT1 et un second enroulement d'antenne AT2. Les deux enroulements d'antenne AT1 et AT2 sont connectés électriquement à l'aide de via ou perforations métalliques. La carte CD1 comprend également un motif M1 et un motif M2 situés au centre de l'antenne. Les deux motifs M1 et M2 sont connectés électriquement à l'aide de via ou perforations métalliques. Ces deux motifs sont également chacun connectés électriquement à l'antenne.

Les enroulements AT1 et AT2 de l'antenne ainsi que les motifs M1 et M2 sont situés dans un substrat lui-même situé dans un évidement de la zone métallique. Les différentes couches de la carte CD1 sont illustrés plus en détail sur les figures 2a et 2b. Une ou plusieurs couches transparentes, de protection par exemple, peuvent également être présentes sur la couche métallique, comme représentées en figure 2a et 2b.

Les motifs M1 et M2 comprennent des traces métalliques circulaires centrées sur le centre des enroulements de l'antenne. Le motif comprend en outre une partie centrale C₁ de forme ronde, en matière conductrice (respectivement C'₁ sur l'autre face). Chacune des traces T₁₁, T₁₂ et T₁₃ (respectivement T'₁₁, T'₁₂ et T'₁₃ sur l'autre face) est isolée de la trace voisine par un espace en matériau non conducteur, tel le substrat comprenant l'antenne et le motif. De plus, chacune des traces ne forme pas une surface circulaire fermée et est ouverte par un espace P₂ reliant le centre C₁ au substrat compris entre le motif et l'antenne. Ainsi, les traces en matériau conducteur sont distantes l'une de l'autre afin de laisser passer un champ magnétique à travers ladite antenne et configurées de manière à ne pas former de boucle fermée pour éviter la formation de courants de Foucault sur la carte CD1. Le motif en matériau conducteur forme un circuit capacitif. Il est configuré pour que la capacité formée par le motif associée à la capacité de ladite antenne permette au circuit résonnant formé par l'antenne et le motif de résonner à une fréquence de communication déterminée.

Selon certains modes de réalisation, sur une première face de la carte, le rayon du cercle constitué par la spire la plus interne de l'enroulement AT1 est de 11.51 mm et celui de la spire la plus externe est de 12.12 mm. Sur une seconde face, ces rayons, pour l'enroulement AT2, sont respectivement de 11.31 mm et de 12.32 mm. L'aire située à l'intérieure de la spire interne de l'enroulement AT1 ou AT2 peut être sensiblement égale à 387 mm².

Ainsi les deux enroulements AT1 et AT2 peuvent ne pas se superposer exactement, chacun d'un côté de la carte mais être légèrement décalés.

Les figures 2a et 2b représentent respectivement une vue éclatée et une vue assemblée d'une carte à puce 1 selon un mode de réalisation de l'invention.

Dans les exemples donnés, la carte à puce est au format ID1 d'une carte de crédit, bien que d'autres formes soient possibles pour mettre en œuvre l'invention.

Sur la figure 2a, on observe une première couche en matériau plastique 101a et une seconde couche plastique 101b, dont l'un des objectifs est de venir protéger les couches internes de la carte à puce CD1. Les couches 101a et 101b, optionnelles, sont par exemple réalisées en polycarbonate et préférentiellement transparentes.

Sous les couches 101a et 101b, sont déposées respectivement des couches en résine 102a et 102b. L'un des objectifs des couches en résine est de venir sceller les couches internes de la carte à puce CD1.

La carte à puce CD1 est formée ou comprend une couche métallique 103 comprenant une zone d'évidement 104 dans laquelle se loge (inséré) un substrat 105. La zone d'évidement 104 est une ouverture ou zone traversante ménagée dans la couche métallique 103 pour permettre le positionnement de l'antenne AT1 et éventuellement de l'antenne AT2 (l'antenne AT2 étant reliée à l'antenne AT1).

La forme et les dimensions de cette zone d'évidemment 104 peuvent être adaptées selon le cas. A titre d'exemple, la zone d'évidement 104 est rectangulaire. Cette couche métallique 103 peut être constituée d'un seul métal, tel que de l'acier inox ou de l'aluminium par exemple, ou d'un alliage de plusieurs métaux différents. La couche métallique 103 peut comprendre une pluralité de sous-couches métalliques.

Selon un exemple particulier, le corps de carte 100 et plus généralement la carte à puce CD1 est dépourvue de ferrite, ce qui permet de simplifier la fabrication de la carte.

Une antenne AT1 ainsi qu'un motif M1 en matériau conducteur tels que divulgué par les modes de réalisation de la présente invention, par exemple en référence aux figures w3, 4 et 5, sont disposés sur un substrat 105. Comme illustré sur la figure 2a, la carte CD1 peut être équipée d'une antenne comprenant un premier enroulement noté AT1 et un second enroulement noté AT2, un enroulement étant présent de chaque côté du substrat et de ce fait sur chaque face de la carte à puce CD1, les deux enroulements étant connectés physiquement par un via (ou une perforation métallique) et de deux motifs M1 et M2 en matériau conducteur, un motif étant respectivement connecté physiquement à chaque enroulement. La présence d'un enroulement sur chacune des faces, permet d'utiliser au mieux la surface disponible sur le substrat et donc d'optimiser l'énergie captée dans le rayonnement électromagnétique ambiant ; le nombre de spires sur chacune des faces du substrat est avantageusement compris entre deux et cinq, ce qui revient à n'occuper qu'une fraction modeste de la surface du support auprès de son contour, typiquement entre 5 et 10% de cette surface.

Sur la figure 2b, on observe une vue de profil de la carte à puce CD1, les couches mentionnées en référence à la figure 2a étant assemblées pour former la carte à puce. Lors de l'assemblage de la carte CD1, la résine 102a vient épouser la surface entre l'ensemble formé de la couche métallique 103 et du substrat 105 et la couche plastique 101a.

On constate ainsi que le motif en matériau conducteur placé au centre de l'antenne, peut permettre de combler l'espace qui existerait en son absence dans le centre de l'antenne et ainsi peut permettre une meilleure adhésion des couches, par exemple lors de l'application d'une couche de résine. Ainsi, la carte possède une surface dont l'homogénéité structurelle est améliorée, la rendant ainsi plus robuste. Autrement dit, le motif permet un meilleur remplissage de la partie centrale de l'antenne de chaque côté du PCB apportant plus d'homogénéité lors de l'application de la résine et donc permettant d'éviter ces problèmes structurels.

Bien entendu, la carte à puce CD1 peut comprendre d'autres éléments ou couches, non représentés sur les figures. La carte à puce CD1 peut notamment comprendre une puce RF, RF signifiant radio-fréquence tout au long de la description. La puce RF est configurée pour établir une communication sans contact avec un terminal externe (non représenté) en utilisant l'antenne comprise dans la carte à puce. Pour ce faire, la puce RF est connectée électriquement à l'antenne AT1 (et à l'antenne AT2 si présente).

Ainsi, la présente invention concerne une carte à puce comprenant :
- un corps de carte formé au moins en partie par une couche métallique comprenant une zone d'évidement et au moins deux couches en plastiques de part et d'autre de la couche métallique;
- au moins une antenne RF disposée dans ou en regard de la zone d'évidement;
- un module comportant une puce RF , le module étant positionné dans une cavité traversante d'une couche en plastique et étant connecté électriquement à l'antenne RF;
- un motif en matériau conducteur connecté en parallèle à ladite au moins une antenne et disposé dans ou en regard de la zone d'évidement et comprenant
   - une zone centrale dont la surface conductrice est inférieure ou égale à 20% de la surface d'une zone centrale circonscrite par ladite antenne
   - au moins deux traces en matériau conducteur séparées l'une de l'autre et s'étendant à partir de ladite zone centrale dudit motif, lesdites au moins deux traces métalliques étant distantes l'une de l'autre afin de laisser passer un champ magnétique à travers ladite antenne et configurées de manière à ne pas former de boucle fermée pour éviter la formation de courants de Foucault sur ladite carte,
ledit motif en matériau conducteur étant configuré pour former une capacité connectée électriquement à l'antenne, dont la valeur est déterminée pour que la capacité formée par ledit motif associée à la capacité de ladite antenne permette au circuit résonnant formé par l'antenne et ledit motif de résonner à une fréquence de communication déterminée.

Préférentiellement, toutes les traces d'un motif sont situées dans un même plan horizontal par rapport aux faces de la carte à puce.

Sur les figures 2a et 2b, on observe que le motif en matériau conducteur (chaque motif en matériau conducteur de chaque côté de la carte) est positionné au centre de l'antenne, et constitué d'au moins deux traces métalliques. On constate sur les figures 2a et 2b que le motif en matériau conducteur comprend par exemple quatre traces en matériau conducteur.

La formation du motif sous la forme de traces peut aider à ne pas perturber le champ magnétique et ainsi à ne pas modifier le fonctionnement de l'antenne

**Les** **figures 3, 4****, et** **5** permettent d'illustrer des exemples de motifs en matériau conducteur, M1 ou M2, dont les caractéristiques peuvent permettre d'assurer une meilleure homogénéité de la carte tout en ne perturbant pas, voire en améliorant, les performances de l'antenne.

Les motifs des **figures 3, 4** **et** **5** sont tels qu'ils occupent entre 60 et 90% de la surface créée au centre de l'antenne, c'est-à-dire de la surface délimitée par la spire interne de l'antenne.

Le motif consiste en au moins deux traces conductrices ayant au moins un espace entre elles et au moins un espace avec la spire la plus interne/proche de l'antenne, de chaque côté du substrat. Plus de deux traces peuvent être utilisées, sous réserve que chaque paire soit séparée par un espace. Toutes les traces de chaque côté du substrat représentent une surface galvanique continue. Les traces conductrices de chaque motif sont configurées de manière à éviter de former une boucle pour éviter la formation de courants de Foucault dans cette forme métallique faisant face au champ magnétique incident.

De plus, la partie centrale du motif, représentée sur les **figures 3, 4** **et** **5** respectivement par les références C₁, C₂ et C₃ occupe une surface inférieure ou égale à 20% de la surface délimitée par la spire interne de l'antenne et comprise à l'intérieur de cette spire.

La partie centrale de chaque motif peut consister en un patch (ou surface) métallique continu ayant une surface de moins de 20% de la surface interne définie par la surface comprise à l'intérieur de la spire la plus interne de l'antenne pour rendre les pertes liées au courant de Foucault négligeables.

En formant le motif en matériau conducteur par des traces conductrices séparées, pouvant être entrelacées, les lignes de champ magnétique induit peuvent traverser l'antenne sans modifier le champ magnétique, et ainsi le comportement de l'antenne n'est pas modifié. De plus, l'utilisation de motifs dont les traces conductrices ne forment pas de boucle fermée peut permettre de réduire les effets des courants de Foucault, dont les effets seront négligeables.

Le motif en matériau conducteur apporte une capacité supplémentaire à la capacité de l'antenne, augmentant la capacité totale de l'antenne. Ainsi, pour une même fréquence de résonnance souhaitée, le diamètre de la spire la plus interne de l'antenne est plus large, avec un nombre de spires réduit et le même pas d'antenne (ou « antenna pitch » an anglais), que pour une antenne sans ce motif en matériau conducteur de l'état de l'art, tout en conservant une résistance faible.

Les caractéristiques de la capacité ainsi ajoutée, notamment l'espacement entre les traces, la forme du motif (largeur, longueur, forme et nombre des traces) sont choisies de sorte que cette capacité définisse, avec l'antenne et la puce, une fréquence de résonance donnée, choisie en fonction des besoins de la carte et notamment des standards avec lesquels la carte doit être conforme.

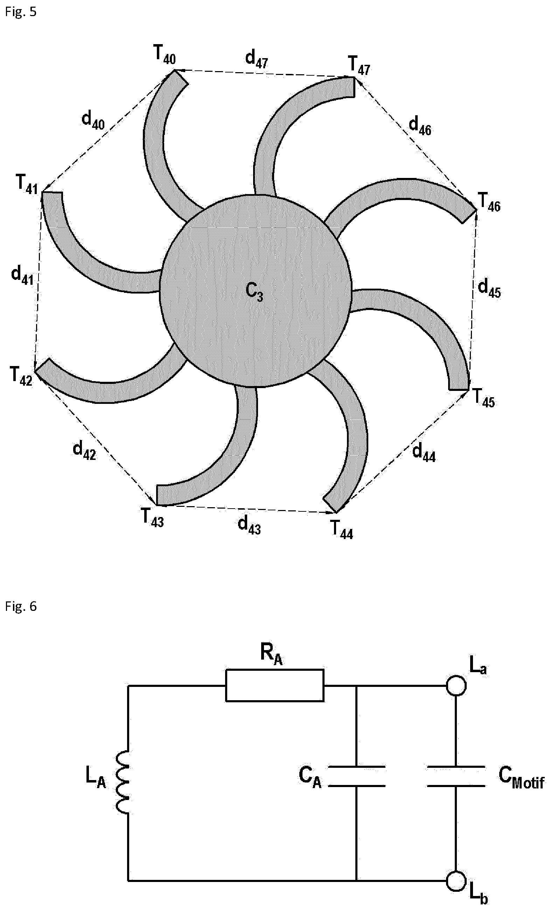

Pour des raisons de clarté les **figures 3, 4** **et** **5** représentent le motif de l'antenne sur une seule face de la carte CD1. On pourra aisément reproduire le motif sur l'autre face, les deux motifs étant en regard l'un de l'autre sur chacune des faces. Par ailleurs, on comprend que les deux motifs sont connectés l'un avec l'autre électriquement, par exemple à l'aide de via et/ou par la connexion électrique avec l'antenne, les spires de l'antenne AT1 étant connectées aux spires de l'antenne AT2, par des vias. Les motifs sont connectés à l'antenne par les bornes La et Lb, qui sont illustrés en **figure 6** sur le schéma électrique équivalent à l'antenne.

**La** **figure 3** représente un premier exemple de motif en matériau conducteur positionné au centre de l'antenne, de chaque côté du substrat. Seule une face est représentée, donc un seul des deux motifs est représenté.

Conformément au mode de réalisation de la figure 3,
- la au moins une antenne comprend une pluralité de spires,
- la zone centrale du motif est de forme ronde et centré sur le centre des spires de l'antenne, et
- les traces du motif sont des traces circulaires centrées sur le centre des spires et formant des anneaux autour de la zone centrale ronde du motif, les traces étant séparées les unes des autres chacune par des premières zones circulaires non conductrice s'étendant entre chacune des traces circulaires et une seconde zone rectiligne reliant les premières zones circulaires non conductrices et coupant chacune des traces circulaires conductrices du motif de manière à ne pas former de boucle fermée pour éviter la formation de courants de Foucault sur la carte,
- les premières zones circulaires non conductrices étant chacune ouvertes de manière à assurer une continuité conductrice entre la zone centrale et les traces du motif.

Le motif comprend trois traces métalliques conductrices T₁₁, T₁₂, T₁₃. Les trois traces métalliques sont des traces de forme circulaire, qui épousent la forme des spires de l'antenne, c'est-à-dire que le centre des traces est le même ou presque le même que le centre des spires de l'antenne. La trace T₁₁, qui représente la trace extérieure du motif, la plus proche des spires, est de préférence située à une distance D de la spire la plus interne de l'antenne. La distance D minimale peut être dépendante de la technologie utilisée et peut être calculée de manière à éviter un court-circuit du motif avec la spire de l'antenne.

Selon certains modes de réalisation, la distance D est comprise entre 200 µm et 1 mm.

Les trois traces sont connectées entre elle et connectées au centre C₁. Elles sont séparées par un espace en matériau non conducteur, dit espace isolant,( tel le substrat), sauf sur une partie de leur circonférence, ceci pour permettre une continuité galvanique entre les traces et le centre. L'espace en matériau non conducteur les séparant partiellement relie les espaces présents entre toutes les traces à la zone non conductrice située entre l'antenne (son enroulement le plus interne) et la trace la plus externe du motif. Autrement dit, une trace circulaire est séparée de la ou des traces adjacentes par un espace isolant circulaire épousant la circonférence des traces, sauf sur une partie de sa circonférence, laissant une ouverture reliant les traces entre elles et les reliant avec le centre du motif. Cette ouverture peut par exemple être d'une largeur d₂ de 200 µm.

L'ouverture conductrice laissée entre les traces et le centre du motif peut par exemple se situer diamétralement opposée à l'espace isolant rejoignant le centre du motif à la zone non conductrice située entre l'antenne (son enroulement le plus interne) et la trace la plus externe du motif.

On peut noter que cette ouverture, peut être différente pour chaque trace.

Selon certains modes de réalisation, la distance d₂ est déterminée pour permettre de conserver un circuit ouvert. Les distances d₂, d₃, d₄ peuvent être égales ou toutes différentes. Prendre des distances d₂, d₃ et d₄ identiques aide à améliorer la tenue mécanique car la symétrie est meilleure et peut aussi faciliter le procédé de fabrication du circuit imprimé, notamment lors de bains de gravure chimique.

La trace T₁₁, trace la plus externe, est connectée à une borne Lₐ de l'antenne. Lorsque l'autre face de la carte comprend un second motif en regard du motif tel que décrit, ce second motif est semblable au motif décrit et connecté à une seconde borne L_{b} de l'antenne, plus précisément de l'enroulement de l'antenne présent sur cette seconde face de la carte CD1.

**La** **figure 4** représente un second exemple de motif en matériau conducteur positionné au centre de l'antenne, de chaque côté du substrat. Seule une face est représentée, donc seul un des deux motifs est représenté.

Selon ce mode de réalisation, le motif comprend au moins douze traces en matériau conducteur ou traces conductrices T₂₁, T₂₂, T₂₃, T₂₄, T₂₅, T₂₆, T₂₇, T₂₈, T₂₉, T₃₀, T₃₁, T₃₂. Les douze traces conductrices sont reliées entre elle, à une de leur extrémité, par l'intermédiaire d'une surface centrale C₂ conductrice, celle-ci pouvant être une surface ronde, dont la surface est au maximum égale à 20% de la taille de la surface délimitée par la spire interne de l'antenne et comprise à l'intérieur de cette spire. Selon d'autres modes de réalisation, cette surface centrale peut être d'une autre forme que ronde, par exemple elliptique, carrée, rectangle. Cette surface centrale C₂ peut être métallique.

Les distances d₂₁, d₂₂, d₂₃ ...à d₃₂ sont égales ou différentes et représentent l'espacement entre les traces. Selon certains modes de réalisation, les distances d₂₁ à d₃₂, sont égales et selon certains modes de réalisation, elles sont différentes. Prendre des distances d₂₁ à d₃₂ identiques aide à améliorer la tenue mécanique car la symétrie est meilleure et peut aussi faciliter le procédé de fabrication du circuit imprimé, notamment lors de bains de gravure chimique.

Il est avantageux de prendre des traces fines (encore appelés brins), d'un ordre de grandeur de 200 µm. Ceci peut aider à réduire les courants de Foucault dans chaque brin. Cependant, plus les brins sont fins, plus le nombre de brins doit être élevé de manière à atteindre une valeur de capacitance souhaitée. Ainsi, la taille et le nombre de brins peuvent être déterminés en fonction de la valeur de capacitance à obtenir.

Les douze traces T₂₁, T₂₂, T₂₃, T₂₄, T₂₅, T₂₆, T₂₇, T₂₈, T₂₉, T₃₀, T₃₁, T₃₂ peuvent être de même longueur ou de longueur différente. Lorsque les traces sont de même longueur, on améliore avantageusement le fluage de résine en le rendant plus homogène.

Les douze traces sont de forme rectangulaire. Elles sont configurées pour former une surface fonction d'une valeur cible de capacité.

L'extrémité des traces non reliée à la surface centrale est libre et située à une distance D' de la spire interne de l'antenne. La distance D' minimale peut être dépendante de la technologie utilisée et peut être calculée de manière à éviter un court-circuit du motif avec la spire de l'antenne.

**La** **figure 5** représente un troisième exemple de motif en matériau conducteur positionné au centre de l'antenne, de chaque côté du substrat. Seule une face est représentée, donc seul un des deux motifs est représenté.

Selon ce mode de réalisation, le motif en matériau conducteur comprend au moins 8 traces conductrices T₄₀, T₄₁, T₄₂, T₄₃, T₄₄, T₄₅, T₄₆, T₄₇. Les huit traces conductrices sont reliées entre elle, à une de leur extrémité, par l'intermédiaire d'une surface centrale C₃ conductrice, celle-ci pouvant être une surface ronde, dont la surface est au maximum égale à 20% de la taille de la surface délimitée par la spire interne de l'antenne et comprise à l'intérieur de cette spire. Selon d'autres modes de réalisation, cette surface centrale peut être d'une autre forme que ronde, par exemple elliptique, carrée, rectangle. Cette surface centrale C₃ peut être métallique.

Les distances d₄₀, d₄₂, d₄₂...à d₄₇ sont égales ou différentes et représentent l'espacement entre les traces. Selon certains modes de réalisation, les distances d₃₁ à d₃₈, sont égales et selon certains modes de réalisation, elles sont différentes. Prendre des distances d₄₀ à d₄₇ identiques aide à améliorer la tenue mécanique car la symétrie est meilleure et peut aussi faciliter le procédé de fabrication du circuit imprimé, notamment lors de bains de gravure chimique.

Il est avantageux de prendre des traces fines (encore appelés brins), d'un ordre de grandeur de 200 µm. Ceci peut aider à réduire les courants de Foucault dans chaque brin. Cependant, plus les brins sont fins, plus le nombre de brins doit être élevé de manière à atteindre une valeur de capacitance souhaitée. Ainsi, la taille et le nombre de brins peuvent être déterminés en fonction de la valeur de capacitance à obtenir.

Les moins 8 traces conductrices T₄₀, T₄₁, T₄₂, T₄₃, T₄₄, T₄₅, T₄₆, T₄₇ peuvent être de même longueur ou de longueur différente. Lorsque les traces sont de même longueur, on améliore avantageusement le fluage de résine en le rendant plus homogène.

Les douze traces sont de forme rectangulaire. Elles sont configurées pour former une surface fonction d'une valeur cible de capacité.

L'extrémité des traces non reliée à la surface centrale est libre et située à une distance D" de la spire interne de l'antenne La distance D" minimale peut être dépendante de la technologie utilisée et peut être calculée de manière à éviter un court-circuit du motif avec la spire de l'antenne.

**La** **figure 6** représente un exemple de schéma électrique équivalent à l'antenne telle que proposée selon les différents modes de réalisation de l'invention.

On peut y voir l'inductance Lₐ et la capacité Cₐ de l'antenne et une capacité additionnelle C_{motif} correspondant au condensateur formé par les traces métalliques du motif. Le circuit RLC résonnant ainsi constitué de la résistance Ra, de l'impédance La et des capacités Cₐ et C_{motif}, permet d'adapter la fréquence de résonnance de l'antenne de manière à ce qu'elle soit, par exemple égale à 13,56Mhz, ce qui permet une communication en mode sans contact de type RFID avec un lecteur externe, selon l'une des normes ISO 14443, ISO 10373, ISO 18745, ISO 15693, EMVCo. **La** **figure 6** permet de comprendre que les motifs en matériau conducteur sont connectés à Lₐ et L_{b}.

Avantageusement, comme mentionné précédemment, l'antenne peut comprendre des spires disposées sur chaque face du substrat et de ce fait, des vias permettent la connexion des spires d'une face à l'autre, on peut parler dans ce cas de deux antennes AT1 et AT2. Ceci permet une continuité dans les boucles formées par ces spires. Les points de raccordement Lₐ et L_{b} peuvent donc se situer de part et d'autre du substrat.

Pour obtenir une fréquence de résonance de 13.75 Mhz, on peut choisir une valeur d'inductance pour LA de 1.29 µH, une valeur de résistance RA de 4.76 Ohms, une valeur de capacité CA de 1 à 2 pF et une valeur de capacité C_{motif} de 54.23 pF. La capacité de la puce RF, de l'ordre de 50 pF vient en outre s'ajouter à ces deux capacités.

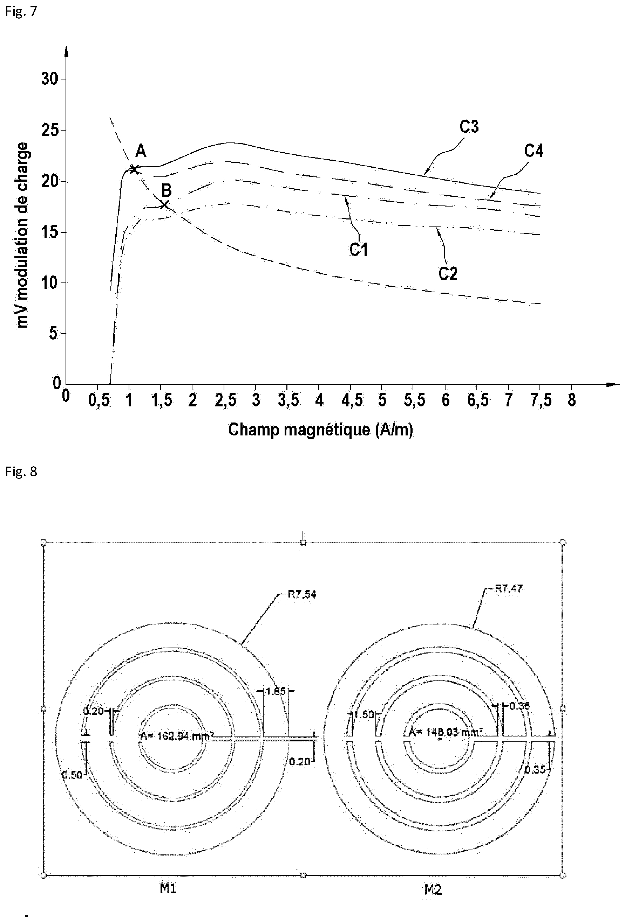

**La** **figure 7** représente une comparaison entre une courbe de réponse obtenue selon l'art antérieur et selon un mode de réalisation de la présente invention. Plus précisément les courbes représentent une comparaison entre le temps de réaction de la carte sans l'invention (courbes C1 et C2) et avec le mode de réalisation du motif en matériau conducteur implémenté en **figure 3** (courbes C3 et C4). Une courbe de référence ISO représentant les valeurs de référence exigées par la norme ISO 14443-2 est également représentée sur la figure. Une courbe haute (C1 ou C3) et une courbe basse (C2 ou C4) illustrent respectivement les bornes hautes et basses entre lesquelles se situe l'amplitude de modulation de charge (en anglais « load modulation amplitude »).

On constate donc que le motif en matériau conducteur peut améliorer le temps de réaction. Ainsi, on constate que l'amplitude de modulation de charge exigée par la norme ISO 14443-2 est atteinte :
- pour un champ magnétique de1.1 Ampère par mètre, représenté par le point A sur la courbe pour une carte CD1 selon le mode de réalisation de **la** **figure 3** et
- pour un champ magnétique de 1.5 Ampère par mètre, représenté par le point B sur la courbe pour une carte qui n implémente pas la présente invention.

On peut donc constater que la carte implémentant un mode de réalisation de la présente invention peut permettre d'une part de déclencher une activation de la carte plus rapidement et d'autre part avec une amplitude de modulation de charge plus grande, que lorsque la présente invention n'est pas implémentée.

La figure 8 représente un mode de réalisation des motifs M1 et M2 situés chacun sur une face de la carte CD1 et illustre des ordres de grandeur de dimensions pouvant être utilisées pour les motifs M1 et M2 selon certains modes de réalisation de l'invention, les motifs M1 et M2 pouvant être des motifs tels que représentés en figure 3.

### Exemples de dimensions du motif M1

On peut noter que la distance d₂ (ainsi que d₃ et d₄) peut être de 0.5 mm. La largeur des traces peut être de 1.65 mm et la largeur de l'espace entre les traces peut être de 0.2 mm. La surface pleine du centre C1 a une aire de 162.94 mm² et la valeur de p₂ est de 0.20 mm. Le rayon externe de la dernière trace est de 7.54mm.

### Exemples de dimensions du motif M2

On peut noter que la distance d₂ (ainsi que d₃ et d₄) peut être de 0.35 mm. La largeur des traces peut être de 1.50 mm et la largeur de l'espace entre les traces peut être de 0.35 mm. La surface pleine du centre C1 a une aire de 148.03 mm² et la valeur de p₂ est de 0.20 mm. Le rayon externe de la dernière trace est de 7.47mm.

La réalisation d'un circuit imprimé a une certaine tolérance en fonction de la technologie utilisée. Comme la capacité apportée par le motif synthétise sa valeur capacitive en fonction de la permittivité du substrat, son épaisseur et la surface des armatures électriques en vis-à-vis, les dimensions du motif sont choisies légèrement plus larges sur une couche que sur l'autre (c'est-à-dire les dimensions de M1 par rapport à M2) afin d'assurer une surface précise des armatures de la capacité et donc de pouvoir contourner l'effet de la tolérance et la précision de la technologie utilisée pour le circuit imprimé.

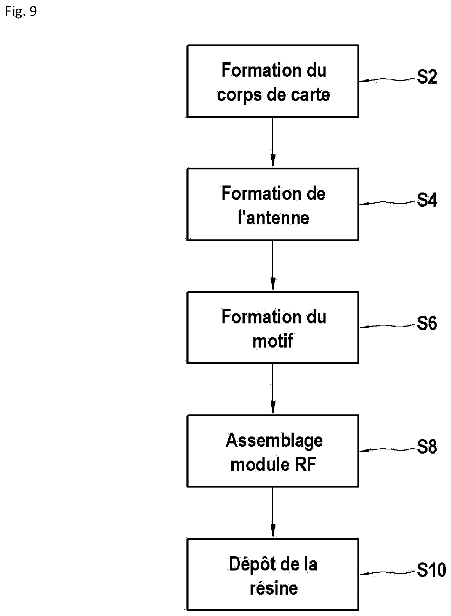

**La** **figure 9** représente schématiquement un procédé de fabrication de l'une des cartes à puce CD1 décrites ci-avant, selon au moins un mode de réalisation particulier. La description ci-avant de la carte à puce CD1 selon divers modes de réalisation en référence aux **figures 2 à 5** s'applique par analogie au procédé de fabrication illustré en **figure 9****.**

Au cours d'une étape S2 de fourniture, on forme (ou fournit) un corps de carte 100 comprenant une couche métallique 103 comme précédemment décrite. En particulier, ce corps de carte 6 est formé au moins en partie par une couche métallique 103, cette couche métallique 103 comprenant une zone d'évidement 104, comme déjà décrit.

Au cours d'une étape S4 de formation, une antenne RF est formée (ou assemblée) sur ou dans le corps de carte 100 dans ou en regard de la zone d'évidement 104 de la couche métallique 103, comme déjà décrit. Selon certains modes de réalisation, l'antenne RF peut comprendre un premier enroulement de spires et un second enroulement de spires, les deux enroulements étant formés (ou assemblés) en regard l'un de l'autre. L'insert d'antenne étant constitué d'un circuit imprimé, celui-ci est réalisé par la technologie classique des circuits imprimés sur un substrat diélectrique tel que, par exemple, le matériau FR4. Les traces d'antenne sont réalisées dans ce cas par un processus classique de circuit imprimé soustractif (gravure mécanique ou chimique) avec une croissance métallique optionnelle électrodéposée ou sans électrolyse pour obtenir une certaine épaisseur.

Au cours d'une étape S6, un motif en matériau conducteur est formé au centre de l'antenne ou plus exactement dans une surface située au centre de l'antenne. Lorsque l'antenne comprend deux enroulements de spires, un premier et un second motifs sont déposés en regard l'un de l'autre de part et d'autre du substrat 105, dans une zone située au centre des enroulements d'antenne, la spire la plus interne de l'enroulement définissant un rond central sans spire. Les traces du motif en matériau conducteur sont réalisées dans ce cas par un processus classique de circuit imprimé soustractif (gravure mécanique ou chimique) avec une croissance métallique optionnelle électrodéposée ou sans électrolyse pour obtenir une certaine épaisseur.

Au cours d'une étape S8, une puce RF est assemblée de sorte que la puce RF est connectées électriquement à l'antenne RF.

Le processus classique de fabrication de la carte CD1 comprend alors au moins un processus de dépôt d'une couche de résine ou de remplissage, étape S10, de la zone de la cavité située au-dessus de l'antenne, afin d'assurer l'étanchéité entre ces deux éléments mécaniquement différents, c'est-à-dire le substrat du circuit imprimé et la couche métallique qui l'entoure. Cette étape de scellement est indispensable pour conférer à l'ensemble du produit un aspect monolithique en vue de satisfaire un certain aspect esthétique, mais surtout pour conférer une stabilité mécanique à la carte en l'empêchant de se déchirer au cours des différents cycles de pliage tout au long du cycle de vie du produit. Ceci est notamment obtenu grâce à la présence du motif en matériau conducteur selon l'un quelconque des modes de réalisation de l'invention, permettant de diminuer la surface laissée vide au centre de l'antenne.

Le procédé peut comprendre en outre une étape supplémentaire (non représentée) de dépôt d'une couche plastique de protection de la carte, représentée par la ou les couches 101a et 101b sur **les** **figures 2a et 2b****.** Cette couche est par exemple une couche en polycarbonate. Dans d'autres modes de réalisation, cette couche peut être du PVC, du PETF ou d'autres polymères.

Un homme du métier comprendra que les modes de réalisation et variantes décrits ci-avant ne constituent que des exemples non limitatifs de mise en œuvre de l'invention. En particulier, l'homme du métier pourra envisager une quelconque adaptation ou combinaison des modes de réalisation et variantes décrits ci-avant, afin de répondre à un besoin bien particulier conformément aux revendications présentées ci-après.

## Revendications

1. Carte à puce (CD1) comprenant :
- un corps de carte (100) formé au moins en partie par une couche métallique (103) comprenant une zone d'évidement (104) et au moins deux couches en plastiques de part et d'autre de la couche métallique;
- au moins une antenne RF (AT1, AT2) disposée dans ou en regard de la zone d'évidement (104) ;
- un module comportant une puce RF , le module étant positionné dans une cavité traversante d'une couche en plastique et étant connecté électriquement à l'antenne RF (AT1);
- un motif en matériau conducteur connecté en parallèle à ladite au moins une antenne (AT1) et disposé dans ou en regard de la zone d'évidement (104) et comprenant
- une zone centrale dont la surface conductrice est inférieure ou égale à 20% de la surface d'une zone centrale circonscrite par ladite antenne
- au moins deux traces en matériau conducteur (Tᵢ) séparées l'une de l'autre et s'étendant à partir de ladite zone centrale dudit motif, lesdites au moins deux traces en matériau conducteur étant distantes l'une de l'autre afin de laisser passer un champ magnétique à travers ladite antenne et configurées de manière à ne pas former de boucle fermée pour éviter la formation de courants de Foucault sur ladite carte,
ledit motif en matériau conducteur étant configuré pour former une capacité connectée électriquement à l'antenne, dont la valeur est déterminée pour que la capacité formée par ledit motif associée à la capacité de ladite antenne permette au circuit résonnant formé par l'antenne et ledit motif de résonner à une fréquence de communication déterminée.

2. Carte à puce selon la revendication 1 dans laquelle ladite antenne comprend deux enroulements RF (AT1, AT2) connectés entre eux électriquement et situés respectivement de part et d'autre de ladite zone d'évidement, deux motifs en matériau conducteur étant situés respectivement de part et d'autre de ladite zone d'évidement et connectés chacun à l'un des enroulements RF.

3. Carte à puce selon l'une des revendications précédentes dans laquelle ladite fréquence de communication déterminée est de 13,56 Mhz et conforme à la norme ISO 14443-2 ou ISO 10373-6.

4. Carte à puce selon l'une des revendications précédentes dans laquelle
- la au moins une antenne comprend une pluralité de spires,
- la zone centrale dudit motif est de forme ronde et centré sur le centre des spires de l'antenne, et
- les traces dudit motif sont des traces circulaires centrées sur le centre des spires et formant des anneaux autour de la zone centrale ronde du motif, les traces étant séparées les unes des autres chacune par des premières zones circulaires non conductrice s'étendant entre chacune des traces circulaires et une seconde zone rectiligne reliant lesdites premières zones circulaires non conductrices et coupant chacune des traces circulaires conductrices dudit motif de manière à ne pas former de boucle fermée pour éviter la formation de courants de Foucault sur ladite carte,
- les premières zones circulaires non conductrices étant chacune ouvertes de manière à assurer une continuité conductrice entre la zone centrale et les traces dudit motif.

5. Carte à puce selon l'une des revendications 1 ou 2 dans laquelle
- la au moins une antenne comprend une pluralité de spires,
- ledit motif en matériau conducteur comprend une surface centrale conductrice de forme ronde centrée sur le centre des spires de l'antenne et interconnectant une pluralité desdites paires de traces en matériau conducteur,
- lesdites traces en matériau conducteur étant de forme rectangulaires et connectées à ladite surface centrale conductrice par l'une de leur extrémité, l'autre extrémité étant libre, et réparties uniformément autour de ladite zone centrale du motif.

6. Carte à puce selon l'une des revendications 1 ou 2 dans laquelle
- la au moins une antenne comprend une pluralité de spires,
- ledit motif en matériau conducteur comprend une surface centrale conductrice de forme ronde centrée sur le centre des spires de l'antenne et interconnectant une pluralité desdites paires de traces en matériau conducteur,
- lesdites traces en matériau conducteur étant de forme hélicoïdale et connectées à ladite surface centrale conductrice par l'une de leur extrémité, l'autre extrémité étant libre, et réparties uniformément autour de ladite zone centrale du motif.

7. Carte à puce selon l'une des revendications 5 ou 6 dans laquelle les traces en matériau conducteur sont réparties uniformément autour de la surface centrale ronde.

8. Carte à puce selon l'une des revendications précédentes dans laquelle le nombre de traces conductrices dépend de la valeur de la capacité connectée.

9. Carte à puce selon l'une des revendications précédentes dans laquelle les traces présentent une largeur configurée pour réduire les courants de Foucault présents sur ladite carte à puce.

10. Procédé de fabrication d'une carte à puce (CD1) formée au moins en partie par un corps de carte comprenant une couche métallique (103), ladite couche métallique comprenant une zone d'évidement (104), le procédé comprenant :
a) formation (S4) sur ou dans le corps de carte d'au moins une première antenne RF (AT1, AT2) dans ou en regard de la zone d'évidement de la couche métallique ;
b) formation (S6) d'au moins un motif en matériau conducteur au centre de la au moins une antenne connecté en parallèle à ladite au moins une antenne et disposé dans ou en regard de la zone d'évidement, le motif métallique comprenant
- une zone centrale dont la surface conductrice est inférieure ou égale à 20% de la surface d'une zone centrale circonscrite par ladite antenne
- au moins deux traces en matériau conducteur (Tᵢ) séparées l'une de l'autre et s'étendant à partir de ladite zone centrale dudit motif, lesdites au moins deux traces métalliques étant distantes l'une de l'autre afin de laisser passer un champ magnétique à travers ladite antenne et configurées de manière à ne pas former de boucle fermée pour éviter la formation de courants de Foucault sur ladite carte, ledit motif en matériau conducteur étant configuré pour former une capacité connectée électriquement à l'antenne, dont la valeur est déterminée pour que la capacité formée par ledit motif associée à la capacité de ladite antenne permette au circuit résonnant formé par l'antenne et ledit motif de résonner à une fréquence de communication déterminée
c) assemblage (S8) d'une puce RF de sorte que ladite puce RF soit connectée électriquement à ladite au moins une antenne,
d) dépôt (S10) d'une couche de résine pour sceller la couche métallique et la zone d'évidement comprenant ladite au moins une antenne et ledit au moins un motif métallique.

## Patentansprüche

1. Chipkarte (CD1), umfassend:
- einen Kartenkörper (100), der mindestens teilweise durch eine Metallschicht (103), die einen Aussparungsbereich (104) umfasst, und mindestens zwei Kunststoffschichten beidseits der Metallschicht gebildet wird;
- mindestens eine RF-Antenne (AT1, AT2), die in oder gegenüber dem Aussparungsbereich (104) angeordnet ist;
- ein Modul, das einen RF-Chip beinhaltet, wobei das Modul in einem durchgehenden Hohlraum einer Kunststoffschicht positioniert ist und mit der RF-Antenne (AT1) elektrisch verbunden ist;
- ein Muster aus leitfähigem Material, das parallel zu der mindestens einen Antenne (AT1) verbunden ist und in oder gegenüber dem Aussparungsbereich (104) angeordnet ist und umfasst
- einen zentralen Bereich, dessen leitfähige Fläche 20 % oder weniger der Fläche eines von der Antenne umschriebenen zentralen Bereichs beträgt
- mindestens zwei Bahnen aus leitfähigem Material (Tᵢ), die voneinander getrennt sind und sich von dem zentralen Bereich des Musters aus erstrecken, wobei die mindestens zwei Bahnen aus leitfähigem Material voneinander beabstandet sind, um ein Magnetfeld durch die Antenne durchzulassen, und so ausgebildet sind, dass sie keine geschlossene Schleife bilden, um die Bildung von Wirbelströmen auf der Karte zu vermeiden,
wobei das Muster aus leitfähigem Material dazu ausgebildet ist, eine mit der Antenne elektrisch verbundene Kapazität zu bilden, deren Wert so bestimmt wird, dass die durch das Muster gebildete Kapazität, die der Kapazität der Antenne zugeordnet ist, dem durch die Antenne und das Muster gebildeten Resonanzkreis ermöglicht, bei einer bestimmten Kommunikationsfrequenz zu resonieren.

2. Chipkarte nach Anspruch 1, wobei die Antenne zwei RF-Wicklungen (AT1, AT2) umfasst, die untereinander elektrisch verbunden sind und beidseits des Aussparungsbereichs gelegen sind, wobei zwei Muster aus leitfähigem Material beidseits des Aussparungsbereichs gelegen sind und jeweils mit einer der RF-Wicklungen verbunden sind.

3. Chipkarte nach einem der vorhergehenden Ansprüche, wobei die bestimmte Kommunikationsfrequenz 13,56 MHz beträgt und der Norm ISO 14443-2 oder ISO 10373-6 entspricht.

4. Chipkarte nach einem der vorhergehenden Ansprüche, wobei
- die mindestens eine Antenne eine Mehrzahl von Windungen umfasst,
- der zentrale Bereich des Musters rund ist und auf das Zentrum der Windungen der Antenne zentriert ist, und
- die Bahnen des Musters kreisförmige Bahnen sind, die auf das Zentrum der Windungen zentriert sind und Ringe um den runden zentralen Bereich des Musters bilden, wobei die Bahnen jeweils voneinander durch nicht leitfähige erste kreisförmige Bereiche getrennt sind, die sich zwischen jeder der kreisförmigen Bahnen erstrecken, und wobei ein zweiter geradliniger Bereich die nicht leitfähigen ersten kreisförmigen Bereiche verbindet und jede der leitfähigen kreisförmigen Bahnen des Musters unterbricht, so dass keine geschlossene Schleife gebildet wird, um die Bildung von Wirbelströmen auf der Karte zu vermeiden,
- die nicht leitfähigen ersten kreisförmigen Bereiche jeweils offen sind, so dass ein leitfähiger Durchgang zwischen dem zentralen Bereich und den Bahnen des Musters gewährleistet ist.

5. Chipkarte nach einem der Ansprüche 1 oder 2, wobei
- die mindestens eine Antenne eine Mehrzahl von Windungen umfasst,
- das Muster aus leitfähigem Material eine runde leitfähige zentrale Fläche umfasst, die auf das Zentrum der Windungen der Antenne zentriert ist und eine Mehrzahl der Paare von Bahnen aus leitfähigem Material miteinander verbindet,
- die Bahnen aus leitfähigem Material rechteckig sind und mit der leitfähigen zentralen Fläche über eines ihrer Enden verbunden sind, wobei das andere Ende frei ist, und gleichmäßig um den zentralen Bereich des Musters verteilt sind.

6. Chipkarte nach einem der Ansprüche 1 oder 2, wobei
- die mindestens eine Antenne eine Mehrzahl von Windungen umfasst,
- das Muster aus leitfähigem Material eine runde leitfähige zentrale Fläche umfasst, die auf das Zentrum der Windungen der Antenne zentriert ist und eine Mehrzahl der Paare von Bahnen aus leitfähigem Material miteinander verbindet,
- die Bahnen aus leitfähigem Material gewendelt sind und mit der leitfähigen zentralen Fläche über eines ihrer Enden verbunden sind, wobei das andere Ende frei ist, und gleichmäßig um den zentralen Bereich des Musters verteilt sind.

7. Chipkarte nach einem der Ansprüche 5 oder 6, wobei die Bahnen aus leitfähigem Material gleichmäßig um die runde zentrale Fläche verteilt sind.

8. Chipkarte nach einem der vorhergehenden Ansprüche, wobei die Anzahl leitfähiger Bahnen vom Wert der verbundenen Kapazität abhängt.

9. Chipkarte nach einem der vorhergehenden Ansprüche, wobei die Bahnen eine Breite aufweisen, die so ausgebildet ist, dass die auf der Chipkarte vorhandenen Wirbelströme verringert werden.

10. Verfahren zur Herstellung einer Chipkarte (CD1), die mindestens teilweise durch einen Kartenkörper gebildet wird, der eine Metallschicht (103) umfasst, wobei die Metallschicht einen Aussparungsbereich (104) umfasst, das Verfahren umfassend:
a) Bilden (S4), auf oder in dem Kartenkörper, mindestens einer ersten RF-Antenne (AT1, AT2) in oder gegenüber dem Aussparungsbereich der Metallschicht;
b) Bilden (S6) mindestens eines Musters aus leitfähigem Material im Zentrum der mindestens einen Antenne, das parallel zu der mindestens eine Antenne verbunden ist und in oder gegenüber dem Aussparungsbereich angeordnet ist, das metallische Muster umfassend
- einen zentralen Bereich, dessen leitfähige Fläche 20 % oder weniger der Fläche eines von der Antenne umschriebenen zentralen Bereichs beträgt
- mindestens zwei Bahnen aus leitfähigem Material (Tᵢ), die voneinander getrennt sind und sich von dem zentralen Bereich des Musters aus erstrecken, wobei die mindestens zwei metallischen Bahnen voneinander beabstandet sind, um ein Magnetfeld durch die Antenne durchzulassen, und so ausgebildet sind, dass sie keine geschlossene Schleife bilden, um die Bildung von Wirbelströmen auf der Karte zu vermeiden, wobei das Muster aus leitfähigem Material dazu ausgebildet ist, eine mit der Antenne elektrisch verbundene Kapazität zu bilden, deren Wert so bestimmt wird, dass die durch das Muster gebildete Kapazität, die der Kapazität der Antenne zugeordnet ist, dem durch die Antenne und das Muster gebildeten Resonanzkreis ermöglicht, bei einer bestimmten Kommunikationsfrequenz zu resonieren
c) Montieren (S8) eines RF-Chips, so dass der RF-Chip mit der mindestens einen Antenne elektrisch verbunden ist,
d) Aufbringen (S10) einer Harzschicht, um die Metallschicht und den Aussparungsbereich, der die mindestens eine Antenne und das mindestens eine metallische Muster umfasst, zu versiegeln.

## Claims

1. Smartcard (CD1) comprising:
- a card body (100) formed at least in part by a metal layer (103) comprising a recess region (104) and at least two plastics layers on either side of the metal layer;
- at least one RF antenna (AT1, AT2) arranged in or opposite the recess region (104);
- a module comprising an RF chip, the module being positioned in a cavity that passes through a plastics layer and being electrically connected to the RF antenna (AT1);
- a conductive-material pattern that is connected in parallel with said at least one antenna (AT1) and arranged in or opposite the recess region (104) and comprises
- a central region, the conductive surface area of which is less than or equal to 20% of the surface area of a central region contained by said antenna
- at least two conductive-material traces (Tᵢ) that are separated from one another and extend from said central region of said pattern, said at least two conductive-material traces being remote from one another in order to allow a magnetic field to pass through said antenna and being configured so as not to form a closed loop, in order to prevent the formation of Foucault currents on said card, said conductive-material pattern being configured to form a capacitance that is electrically connected to the antenna, the value of which is determined so that the capacitance formed by said pattern, which is associated with the capacitance of said antenna, allows the resonant circuit formed by the antenna and said pattern to resonate at a determined communication frequency.

2. Smartcard according to Claim 1, wherein said antenna comprises two RF windings (AT1, AT2) that are electrically connected to one another and respectively situated on either side of said recess region, two conductive-material patterns being respectively situated on either side of said recess region and each connected to one of the RF windings.

3. Smartcard according to either of the preceding claims, wherein said determined communication frequency is 13.56 MHz and conforms to the standard ISO 14443-2 or ISO 10373-6.

4. Smartcard according to one of the preceding claims, wherein
- the at least one antenna comprises a plurality of coils,
- the central region of said pattern is round and centred on the centre of the coils of the antenna, and
- the traces of said pattern are circular traces centred on the centre of the coils and forming rings around the round central region of the pattern, the traces each being separated from one another by first nonconductive circular regions extending between each of the circular traces and a second rectilinear region connecting said first nonconductive circular regions and interrupting each of the conductive circular traces of said pattern so as not to form a closed loop, in order to prevent the formation of Foucault currents on said card,
- the first nonconductive circular regions each being open so as to ensure a conductive continuity between the central region and the traces of said pattern.

5. Smartcard according to either of Claims 1 and 2, wherein
- the at least one antenna comprises a plurality of coils,
- said conductive-material pattern comprises a round conductive central surface centred on the centre of the coils of the antenna and interconnecting a plurality of said pairs of conductive-material traces,
- said conductive-material traces being rectangular, connected to said conductive central surface by one of their ends, the other end being free, and uniformly distributed around said central region of the pattern.

6. Smartcard according to either of Claims 1 and 2, wherein
- the at least one antenna comprises a plurality of coils,
- said conductive-material pattern comprises a round conductive central surface centred on the centre of the coils of the antenna and interconnecting a plurality of said pairs of conductive-material traces,
- said conductive-material traces being helical, connected to said conductive central surface by one of their ends, the other end being free, and uniformly distributed around said central region of the pattern.

7. Smartcard according to either of Claims 5 and 6, wherein the conductive-material traces are uniformly distributed around the round central surface.

8. Smartcard according to one of the preceding claims, wherein the number of conductive traces depends on the value of the connected capacitance.

9. Smartcard according to one of the preceding claims, wherein the traces have a width that is configured to reduce the Foucault currents present on said smartcard.

10. Method for manufacturing a smartcard (CD1) that is formed at least in part by a card body comprising a metal layer (103), said metal layer comprising a recess region (104), the method comprising:
a) forming (S4), on or in the card body, at least one first RF antenna (AT1, AT2) in or opposite the recess region of the metal layer;
b) forming (S6) at least one conductive-material pattern at the centre of the at least one antenna connected in parallel with said at least one antenna and arranged in or opposite the recess region, the metal pattern comprising
- a central region, the conductive surface area of which is less than or equal to 20% of the surface area of a central region contained by said antenna
- at least two conductive-material traces (Tᵢ) that are separated from one another and extend from said central region of said pattern, said at least two metal traces being remote from one another in order to allow a magnetic field to pass through said antenna and being configured so as not to form a closed loop, in order to prevent the formation of Foucault currents on said card,
said conductive-material pattern being configured to form a capacitance that is electrically connected to the antenna, the value of which is determined so that the capacitance formed by said pattern, which is associated with the capacitance of said antenna, allows the resonant circuit formed by the antenna and said pattern to resonate at a determined communication frequency
c) assembling (S8) an RF chip so that said RF chip is electrically connected to said at least one antenna,
d) depositing (S10) a layer of resin in order to seal the metal layer and the recess region comprising said at least one antenna and said at least one metal pattern.
